# FASCICULE DE BREVET EUROPEEN

(11) **EP 2 804 843 B1**
(45) Date de publication et mention de la délivrance du brevet: **02.08.2017**
(21) Numéro de dépôt: 13704165.3
(22) Date de dépôt: 16.01.2013
(51) Int. Cl.: C03C 17/36

(54) **SUBSTRAT MUNI D'UN EMPILEMENT A PROPRIETES THERMIQUES COMPORTANT QUATRE COUCHES FONCTIONNELLES METALLIQUES ET UTILISATION D'UN TEL SUBSTRAT**
SUBSTRAT MIT EINEM STAPEL MIT WÄRMEEIGENSCHAFTEN UND MIT VIER FUNKTIONELLEN METALLFILMEN UND VERWENDUNG EINES SOLCHEN SUBSTRATS
SUBSTRATE PROVIDED WITH A STACK HAVING THERMAL PROPERTIES AND COMPRISING FOUR FUNCTIONAL METAL FILMS AND USE OF SUCH A SUBSTRATE

(30) Priorité: 16.01.2012 FR 1250407
(43) Date de publication de la demande: 26.11.2014
(73) Titulaire: Saint-Gobain Glass France, 92400 Courbevoie (FR)
(72) Inventeur: SANDRE-CHARDONNAL, Etienne, 44000 Nantes (FR)
(74) Mandataire: Saint-Gobain Recherche
(86) Numéro de dépôt international: PCT/FR2013/050100
(87) Numéro de publication internationale: WO 2013/107983

(56) Documents cités:
- FR-A1- 2 862 961
- FR-A1- 2 936 510

## Description

L'invention concerne un substrat transparent en verre, ledit substrat étant revêtu d'un empilement de couches minces comprenant plusieurs couches fonctionnelles pouvant agir sur le rayonnement solaire et/ou le rayonnement infrarouge de grande longueur d'onde.

L'invention concerne plus particulièrement un substrat verrier transparent, muni d'un empilement de couches minces comportant une alternance de « n » couches fonctionnelles métalliques, notamment de couches fonctionnelles à base d'argent ou d'alliage métallique contenant de l'argent, et de « (n + 1) » revêtements antireflet, avec n nombre entier = 4, de manière à ce que chaque couche fonctionnelle soit disposée entre deux revêtements antireflet. Chaque revêtement comporte au moins une couche antireflet et chaque revêtement étant, de préférence, composé d'une pluralité de couches, dont une couche au moins, voire chaque couche, est une couche antireflet.

L'invention concerne plus particulièrement l'utilisation de tels substrats pour fabriquer des vitrages d'isolation thermique et/ou de protection solaire. Ces vitrages peuvent être destinés aussi bien à équiper les bâtiments que les véhicules, en vue notamment de diminuer l'effort de climatisation et/ou d'empêcher une surchauffe excessive (vitrages dits « de contrôle solaire ») et/ou diminuer la quantité d'énergie dissipée vers l'extérieur (vitrages dits « bas émissifs ») entraînée par l'importance toujours croissante des surfaces vitrées dans les bâtiments et les habitacles de véhicules.

Ces substrats peuvent en particulier être intégrés dans des dispositifs électroniques et l'empilement peut alors servir d'électrode pour la conduction d'un courant (dispositif éclairant, dispositif d'affichage, panneau voltaïque, vitrage électrochrome, ...) ou peuvent être intégrés dans des vitrages présentant des fonctionnalités particulières, comme par exemple des vitrages chauffants et en particulier des pare-brise chauffants de véhicule.

Des empilements de quatre couches métalliques fonctionnelles sont connus.

Dans ce type d'empilement, chaque couche fonctionnelle se trouve disposée entre deux revêtements antireflet comportant chacun en général plusieurs couches antireflet qui sont chacune en un matériau du type nitrure et notamment nitrure de silicium ou d'aluminium et/ou du type oxyde. Du point de vue optique, le but de ces revêtements qui encadrent la couche fonctionnelle est « d'antirefléter » cette couche fonctionnelle.

Un revêtement de blocage très fin est toutefois intercalé parfois entre un ou chaque revêtement antireflet et une couche fonctionnelle adjacente : un revêtement de blocage disposé sous la couche fonctionnelle en direction du substrat et un revêtement de blocage disposé sur la couche fonctionnelle à l'opposé du substrat et qui protège cette couche d'une éventuelle dégradation lors du dépôt du revêtement antireflet supérieur et lors d'un éventuel traitement thermique à haute température, du type bombage et/ou trempe.

L'art antérieur connaît par exemple de la demande internationale de brevet N° WO 2005/051858 des empilements à quatre couches fonctionnelles.

Dans les empilements à quatre couches fonctionnelles présentés dans ce document, les épaisseurs de toutes les couches fonctionnelles sont sensiblement identiques, c'est-à-dire que l'épaisseur de la première couche fonctionnelle, la plus proche du substrat, est sensiblement identique à l'épaisseur de la deuxième couche fonctionnelle qui est sensiblement identique à l'épaisseur de la troisième couche fonctionnelle, voire qui est sensiblement identique à l'épaisseur de la quatrième couche fonctionnelle lorsqu'il y a une quatrième couche fonctionnelle. Voir par exemple l'exemple 24 de ce document.

Toutefois, il apparaît que la configuration du double-vitrage de l'exemple 24 de la demande N° WO 2005/051858 ne donne pas entièrement satisfaction car même si sa transmission lumineuse est assez élevée (58,0 %) sa réflexion lumineuse assez basse (12,2 %) et sa transmission énergétique assez faible, son facteur solaire (qui est par nature plus élevé que la transmission énergétique) conduit à une sélectivité qui n'est pas satisfaisante ; en outre la couleur en transmission n'est pas non plus satisfaisante en raison d'une valeur de a* dans le système Lab très négative. On connaît également de FR2 936 510 des empilements comprenant 4 couches fonctionnelles soit ayant toutes la même épaisseur soit ayant les première et quatrième couches plus minces que les deuxième et troisième couches situées au centre de l'empilement. Il apparaît qu'il serait préférable d'obtenir une transmission lumineuse en double vitrage plus élevée (de l'ordre de 60 %), une réflexion lumineuse toujours aussi basse (de l'ordre de 12 %) et un facteur solaire plus bas (de l'ordre de 26 %), afin de pouvoir obtenir une sélectivité élevée de l'ordre de 2,3 ; il apparaît en outre qu'il serait préférable d'obtenir une couleur en réflexion, tant de l'extérieur que de l'intérieur, plus neutre, dans les bleu-vert et qui en outre varie peu suivant l'angle d'observation.

Un but de l'invention est ainsi de fournir un empilement qui présente ces caractéristiques.

Un autre but est de fournir un empilement qui présente une très faible résistance par carré afin en particulier que le vitrage intégrant cet empilement puisse présenter une haute réflexion énergétique et/ou une très basse émissivité et/ou être chauffé par application d'un courant entre deux bus-barres électriquement raccordées à l'empilement, ainsi qu'une transmission lumineuse élevée et une couleur relativement neutre, en particulier en configuration double vitrage ou en configuration feuilletée, et que ces propriétés soient de préférence obtenues après un (ou des) traitement(s) thermique(s) à haute température du type bombage et/ou trempe et/ou recuit, voire que ces propriétés soient conservées dans une plage restreinte que l'empilement subisse ou non un (ou de) tel(s) traitement(s) thermique(s).

L'invention a ainsi pour objet, dans son acception la plus large, un substrat verrier transparent, muni d'un empilement de couches minces comportant une alternance de quatre couches métalliques fonctionnelles, notamment de couches fonctionnelles à base d'argent ou d'alliage métallique contenant de l'argent, et de cinq revêtements antireflet, chaque revêtement antireflet comportant au moins une couche antireflet, de manière à ce que chaque couche métallique fonctionnelle soit disposée entre deux revêtements antireflet, remarquable en ce que l'épaisseur des deuxième, troisième et quatrième couches métalliques fonctionnelles en partant du substrat est sensiblement identique avec un rapport de l'épaisseur d'une couche sur l'épaisseur de la précédente qui est compris entre 0,9 et 1,1 en incluant ces valeurs et l'épaisseur de la première couche métallique fonctionnelle est environ la moitié de l'épaisseur de la deuxième couche métallique fonctionnelle avec un rapport de l'épaisseur de la deuxième couche métallique sur l'épaisseur de la première couche métallique fonctionnelle qui est compris entre 1,9 et 2,2 en incluant ces valeurs.

Les revêtements antireflet situés chacun entre deux couches métalliques fonctionnelles présente des épaisseurs optiques assez proches. Chaque revêtement antireflet situé entre deux couches métalliques fonctionnelles présente, de préférence, une épaisseur optique comprise entre 165 nm et 181 nm en incluant ces valeurs afin de favoriser l'obtention d'une couleur en réflexion dans le bleu-vert. Ceci est d'autant plus surprenant eu égard au déséquilibre entre l'épaisseur de la première couche métallique fonctionnelle et l'épaisseur des autres couches métalliques fonctionnelles.

Par « couleur dans le bleu-vert » au sens de la présente invention, il faut comprendre que dans le système de mesure de couleur Lab, a* est compris entre 0 et - 6.

De préférence, chaque revêtement antireflet situé entre deux couches métalliques fonctionnelles est constitué uniquement d'une ou de plusieurs couches antireflet. De préférence, il n'y a donc pas de couche absorbante dans les revêtements diélectriques, afin de ne pas diminuer la transmission lumineuse.

L'épaisseur de la première couche métallique fonctionnelle est, de préférence, environ la moitié de l'épaisseur de toutes les autres couches métalliques fonctionnelles avec un rapport de la moyenne de l'épaisseur des deuxième, troisième et quatrième couches métalliques fonctionnelles sur l'épaisseur de la première couche métallique fonctionnelle qui est compris entre 1,9 et 2,5 en incluant ces valeurs. Cette règle permet de favoriser l'obtention d'une couleur en réflexion extérieure dans le bleu-vert.

Par « rang » au sens de la présente invention, on entend la numérotation en nombre entier de chaque couche fonctionnelle en partant du substrat : la couche fonctionnelle la plus proche du substrat étant la couche fonctionnelle de rang 1 ou première couche fonctionnelle, la suivante en s'éloignant du substrat étant celle de rang 2 ou deuxième couche fonctionnelle, etc.

Par « rapport de l'épaisseur d'une couche sur l'épaisseur de la précédente » il faut ainsi comprendre le rapport de l'épaisseur de la couche considérée sur l'épaisseur de la couche de rang immédiatement inférieur.

L'épaisseur de chaque couche fonctionnelle est, de préférence, comprise entre 6 et 20 nm en incluant ces valeurs, afin d'obtenir une transmission lumineuse suffisamment élevée.

L'épaisseur e₄₀ en nm de la première couche métallique fonctionnelle en partant du substrat (celle de rang 1) est, de préférence, telle que : 5,5 ≤ e₄₀ ≤ 11 en nm, et de préférence 6 ≤ e₄₀ ≤ 10.

L'épaisseur e₈₀ en nm de la deuxième couche métallique fonctionnelle en partant du substrat (celle de rang 2) est, de préférence, telle que : 11 ≤ e₈₀ ≤ 22 en nm, et de préférence 12 ≤ e₈₀ ≤ 20.

L'épaisseur e₁₂₀ en nm de la troisième couche métallique fonctionnelle en partant du substrat (celle de rang 3) est, de préférence, telle que : 11 ≤ e₁₂₀ ≤ 22 en nm, et de préférence 12 ≤ e₁₂₀ ≤ 20.

L'épaisseur e₁₆₀ en nm de la quatrième couche métallique fonctionnelle en partant du substrat (celle de rang 4) est, de préférence, telle que : 11 ≤ e₁₆₀ ≤ 22 en nm, et de préférence 12 ≤ e₁₆₀ ≤ 20.

Ces plages d'épaisseur pour les couches métalliques fonctionnelles sont les plages pour lesquelles les meilleurs résultats sont obtenus : transmission lumineuse en double vitrage élevée, réflexion lumineuse basse et facteur solaire plus bas, afin de pouvoir obtenir une sélectivité élevée avec en une couleur en réflexion, tant de l'extérieur que de l'intérieur, neutre, dans les bleu-vert.

Dans une variante préférée, l'épaisseur totale des quatre couches métalliques fonctionnelles est comprise entre 30 et 70 nm en incluant ces valeurs, voire cette épaisseur totale est comprise entre 35 et 65 nm.

Il est important de constater ici que la répartition particulière dans la distribution des épaisseurs des quatre couches fonctionnelles n'est pas la même que la répartition dans la distribution des épaisseurs de toutes les couches de l'empilement (en prenant en compte les couches antireflet).

Sauf mention contraire, les épaisseurs évoquées dans le présent document sont des épaisseurs physiques, ou réelles (et non pas des épaisseurs optiques).

Par « épaisseur optique » on entend au sens de l'invention, comme habituellement, le produit de l'épaisseur physique (ou réelle) de la couche avec son indice de réfraction mesuré comme d'habitude à 550 nm.

Par « épaisseur optique totale » on entend au sens de l'invention la somme de toutes les épaisseurs optiques des couches considérées, chaque épaisseur optique étant, comme expliqué ci-avant, le produit de l'épaisseur physique (ou réelle) de la couche avec son indice de réfraction mesuré comme d'habitude à 550 nm.

Ainsi, l'épaisseur optique totale du premier revêtement antireflet (celui de rang 1) sous-jacent à la première couche métallique fonctionnelle est constituée de la somme de toutes les épaisseurs optiques des couches diélectriques de ce revêtement qui sont disposées entre le substrat et la première couche métallique fonctionnelle ou entre le substrat et le revêtement de sous-blocage de la première couche métallique si ce revêtement de sous-blocage est présent.

De même, l'épaisseur optique totale du dernier revêtement antireflet (celui de rang 5), sus-jacent à la quatrième couche métallique fonctionnelle est constituée de la somme de toutes épaisseurs optiques des couches diélectriques de ce revêtement qui sont disposées au-dessus de la quatrième couche métallique fonctionnelle, à l'opposé du substrat, ou au-dessus du revêtement de sur-blocage de cette quatrième couche métallique fonctionnelle si ce revêtement de sur-blocage est présent.

L'épaisseur optique totale d'un revêtement antireflet intermédiaire (ceux de rang 2, 3 et 4), sus-jacent à une couche métallique fonctionnelle et sous-jacent à la couche métallique fonctionnelle suivante en s'éloignant du substrat, est constituée de la somme de toutes épaisseurs optiques des couches diélectriques de ce revêtement qui sont disposées entre ces deux couches métalliques fonctionnelles, au-dessus du revêtement de sur-blocage de la couche métallique fonctionnelle s'il est présent et en dessous du revêtement de sous-blocage de la couche métallique fonctionnelle suivante s'il est présent.

Par ailleurs, lorsqu'il est fait état d'un positionnement vertical d'une couche (ex. : en dessous /au-dessus), c'est toujours en considérant que le substrat porteur est positionné horizontalement, en bas, avec l'empilement sur lui ; Lorsqu'il est précisé qu'une couche est déposée directement sur une autre, cela signifie qu'il ne peut y avoir une (ou plusieurs) couche(s) intercalée(s) entre ces deux couches. Le rang des couches fonctionnelles est ici toujours défini en partant du substrat porteur de l'empilement (substrat sur la face duquel est déposé l'empilement) et en se référant aux couches de même nature.

Dans une variante particulière de l'invention, chacun des revêtements antireflet comporte au moins une couche antireflet à base de nitrure de silicium, éventuellement dopé à l'aide d'au moins un autre élément, comme l'aluminium. Ceci est particulièrement avantageux pour les empilements de couches minces à bomber/tremper ou pour les empilements de couches minces bombables/trempables.

Dans une autre variante particulière de l'invention, la dernière couche de chaque revêtement antireflet sous-jacent à une couche fonctionnelle est une couche antireflet de mouillage à base d'oxyde cristallisé, notamment à base d'oxyde de zinc, éventuellement dopé à l'aide d'au moins un autre élément, comme l'aluminium, afin de favoriser l'obtention de couches fonctionnelles cristallisées.

La présente invention se rapporte par ailleurs au vitrage incorporant au moins un substrat selon l'invention, éventuellement associé à au moins un autre substrat et notamment un vitrage multiple du type double-vitrage ou triple vitrage ou un vitrage feuilleté et en particulier un vitrage feuilleté comportant des moyens pour la connexion électrique de l'empilement de couches minces afin de permettre de réaliser un vitrage feuilleté chauffant, ledit substrat porteur de l'empilement pouvant être bombé et/ou trempé.

Chaque substrat du vitrage peut être clair ou coloré. Un des substrats au moins notamment peut être en verre coloré dans la masse. Le choix du type de coloration va dépendre du niveau de transmission lumineuse et/ou de l'aspect colorimétrique recherchés pour le vitrage une fois sa fabrication achevée.

Le vitrage selon l'invention peut présenter une structure feuilletée, associant notamment au moins deux substrats rigides du type verre par au moins une feuille de polymère thermoplastique, afin de présenter une structure de type verre/empilement de couches minces/feuille(s)/verre. Le polymère peut notamment être à base de polyvinylbutyral PVB, éthylène vinylacétate EVA, polyéthylène téréphtalate PET, polychlorure de vinyle PVC.

Le vitrage peut alors présenter une structure de type : verre/empilement de couches minces/feuille(s) de polymère/verre.

Les vitrages selon l'invention sont aptes à subir un traitement thermique sans dommage pour l'empilement de couches minces. Ils sont donc éventuellement bombés et/ou trempés.

Le vitrage peut être bombé et/ou trempé en étant constitué d'un seul substrat, celui muni de l'empilement. Il s'agit alors d'un vitrage dit « monolithique ». Dans le cas où ils sont bombés, notamment en vue de constituer des vitrages pour véhicules, l'empilement de couches minces se trouve de préférence sur une face au moins partiellement non plane.

Le vitrage peut aussi être un vitrage multiple, notamment un double-vitrage, au moins le substrat porteur de l'empilement pouvant être bombé et/ou trempé. Il est préférable dans une configuration de vitrage multiple que l'empilement soit disposé de manière à être tourné du côté de la lame de gaz intercalaire. Dans une structure feuilletée, le substrat porteur de l'empilement peut être en contact avec la feuille de polymère.

Le vitrage peut aussi être un triple vitrage constitué de trois feuilles de verre séparée deux par deux par une lame de gaz. Dans une structure en triple vitrage, le substrat porteur de l'empilement peut être en face 2 et/ou en face 5, lorsque l'on considère que le sens incident de la lumière solaire traverse les faces dans l'ordre croissant de leur numéro.

Lorsque le vitrage est monolithique ou multiple du type double-vitrage, triple vitrage ou vitrage feuilleté, au moins le substrat porteur de l'empilement peut être en verre bombé ou trempé, ce substrat pouvant être bombé ou trempé avant ou après le dépôt de l'empilement.

L'invention concerne en outre l'utilisation du substrat selon l'invention, pour réaliser un vitrage à haute réflexion énergétique et/ou un vitrage à très basse émissivité et /ou un vitrage chauffant avec un revêtement transparent chauffant par effet Joule.

L'invention concerne en outre l'utilisation du substrat selon l'invention, pour réaliser une électrode transparente d'un vitrage électrochrome ou d'un dispositif d'éclairage ou d'un dispositif de visualisation ou d'un panneau photovoltaïque.

Le substrat selon l'invention peut-être en particulier utilisé pour réaliser un substrat à haute réflexion énergétique et/ou un substrat à très basse émissivité et /ou un revêtement transparent chauffant d'un vitrage chauffant.

Le substrat selon l'invention peut-être en particulier utilisé pour réaliser une électrode transparente d'un vitrage électrochrome (ce vitrage étant monolithique ou étant multiple du type double-vitrage ou triple vitrage ou vitrage feuilleté) ou d'un dispositif d'éclairage ou d'un écran de visualisation ou d'un panneau photovoltaïque. (« transparent » est à comprendre ici comme « non opaque »).

L'empilement selon l'invention permet d'obtenir un substrat revêtu d'un empilement et qui présente une transmission lumineuse élevée (> à 55 %, et même > 60 %), une réflexion lumineuse faible (< à 14%), un facteur solaire élevé et une couleur en réflexion peu prononcée (avec des valeurs de a* et b* dans le système Lab proches de zéro) qui en outre varie peu en fonction de l'angle d'observation.

L'empilement selon l'invention permet ainsi d'atteindre une sélectivité élevée, supérieure à 2,1.

Les détails et caractéristiques avantageuses de l'invention ressortent des exemples non limitatifs suivants, illustrés à l'aide des figures ci-jointes :
- la figure 1 illustre un exemple de structure d'un empilement à quatre couches métalliques fonctionnelles selon l'invention ;
- la figure 2 illustre les variations de couleur en réflexion en fonction de l'angle dans le système Lab pour l'exemple 1, observées de l'extérieur (« out ») et de l'intérieur (« in ») ;
- la figure 3 illustre les variations de couleur en réflexion en fonction de l'angle dans le système Lab pour l'exemple 2, observées de l'extérieur (« out ») et de l'intérieur (« in ») ;
- la figure 4 illustre les variations de couleur en réflexion en fonction de l'angle dans le système Lab pour l'exemple 3, observées de l'extérieur (« out ») et de l'intérieur (« in ») ;
- la figure 5 illustre les variations de couleur en réflexion en fonction de l'angle dans le système Lab pour l'exemple 4, observées de l'extérieur (« out ») et de l'intérieur (« in ») ; et
- la figure 6 illustre les variations de couleur en réflexion en fonction de l'angle dans le système Lab pour l'exemple 24 de la demande internationale de brevet N° WO 2005/051858, observées de l'extérieur («out») et de l'intérieur (« in »).

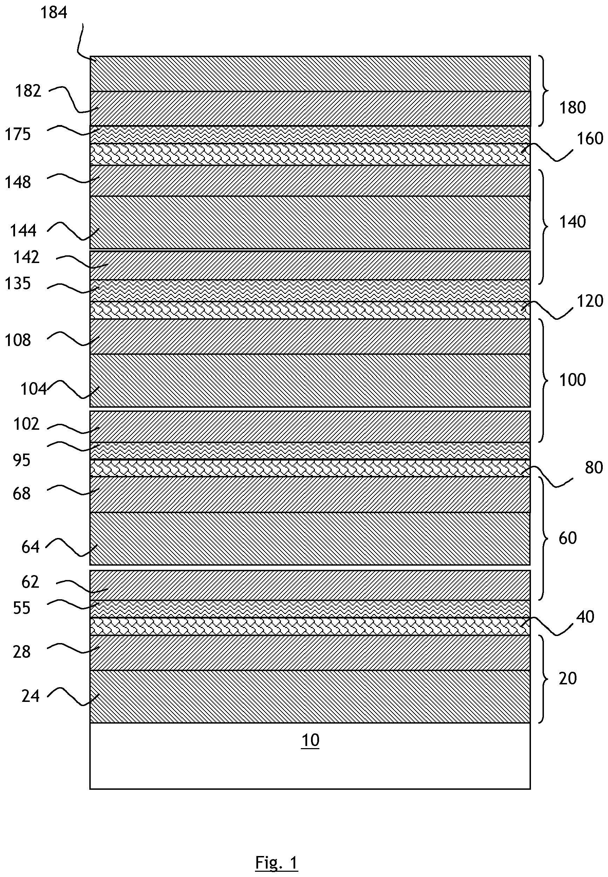

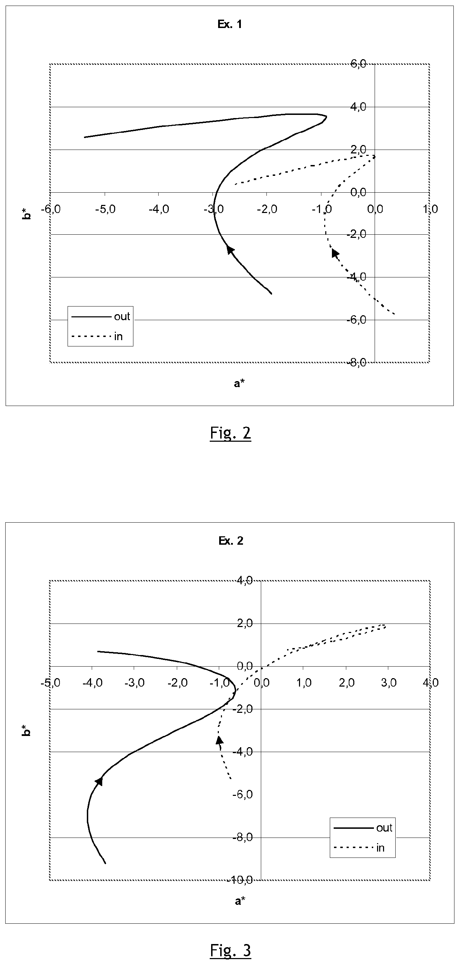

En figure 1, les proportions entre les différents éléments ne sont pas respectées afin de faciliter sa lecture ; Pour les figures 2 à 6, les flèches indiquent les variations obtenues de 0° par rapport à la normale à la surface extérieure (début de la courbe) jusqu'à un angle de 70 ° par rapport à la normale à la surface extérieure (fin de la courbe en suivant le sens de la flèche).

La figure 1 illustre une structure d'empilement à quatre couches métalliques fonctionnelles 40, 80, 120, 160, cette structure étant déposée sur un substrat 10 verrier, transparent.

Chaque couche fonctionnelle 40, 80, 120, 160 est disposée entre deux revêtements antireflet 20, 60, 100, 140, 180 de telle sorte que la première couche fonctionnelle 40 en partant du substrat est disposée entre les revêtements antireflet 20, 60 ; la deuxième couche fonctionnelle 80 est disposée entre les revêtements antireflet 60, 100, la troisième couche fonctionnelle 120 est disposée entre les revêtements antireflet 100, 140 et la quatrième couche fonctionnelle 160 est disposée entre les revêtements antireflet 140 et 180.

Ces revêtements antireflet 20, 60, 100, 140, 180 comportent chacun au moins une couche antireflet diélectrique 24, 28 ; 62, 64, 68 ; 102, 104, 108 ; 142, 144, 148 ; 182, 184.

Eventuellement, d'une part chaque couche fonctionnelle 40, 80, 120, 160 peut être déposée sur un revêtement de sous-blocage (non illustré) disposé entre le revêtement antireflet sous-jacent à la couche fonctionnelle et la couche fonctionnelle et d'autre part chaque couche fonctionnelle 40, 80, 120, 160 peut être déposée directement sous un revêtement de sur-blocage 55, 95, 135, 175 disposé entre la couche fonctionnelle et le revêtement antireflet sus-jacent à cette couche.

Ces revêtements de blocages ne sont pas pris en considération dans la définition optique des revêtements antireflet de l'empilement.

Une première série de quatre exemples a été réalisée ; ces exemples sont numérotés de 1 à 4 ci-après.

Pour ces exemples, les revêtements antireflet 20, 60, 100, 140, 180 ne sont définis que par leurs épaisseurs optiques (en considérant que l'indice de réfraction de la matière antireflet qui compose les revêtements antireflet est mesuré à 550 nm, comme habituellement).

Le tableau 1 suivant résume les épaisseurs en nanomètres de chaque couche ou revêtement qui constituent l'empilement en fonction de leurs positions vis-à-vis du substrat porteur de l'empilement (dernière ligne en bas du tableau) ; les indices des épaisseurs de la 1^{ère} colonne correspondent aux références de la figure 1.

**Tableau 1**

| | | Ex. 1 | Ex. 2 | Ex. 3 | Ex. 4 |
|---|---|---|---|---|---|
| e₁₈₀ | Diélectrique 5 | 91 | 86 | 75 | 85 |
| e₁₆₀ | Ag4 | 17,1 | 17,1 | 17,2 | 15,5 |
| e₁₄₀ | Diélectrique 4 | 181 | 178 | 176 | 175 |
| e₁₂₀ | Ag3 | 15,7 | 15,8 | 13,3 | 17,1 |
| e₁₀₀ | Diélectrique 3 | 168 | 167 | 141 | 172 |
| e₈₀ | Ag2 | 15,2 | 14,3 | 8,6 | 15,1 |
| e₆₀ | Diélectrique 2 | 175 | 165 | 118 | 165 |
| e₄₀ | Ag1 | 7,7 | 6,7 | 6,2 | 9,5 |
| e₂₀ | Diélectrique 1 | 89 | 45 | 67 | 80 |
| | Verre | | | | |

Le tableau 2 suivant résume les rapports d'épaisseurs des couches fonctionnelles :

**Tableau 2**

| | Ex. 1 | Ex. 2 | Ex. 3 | Ex. 4 |
|---|---|---|---|---|
| e₁₆₀/e_{12O} | 1,09 | 1,08 | 1,30 | 0,91 |
| e₁₂₀/e₈₀ | 1,03 | 1,10 | 1,55 | 1,13 |
| e₈₀/e₄₀ | 1,98 | 2,13 | 1,39 | 1,60 |
| ((e₈₀+e₁₂₀+e₁₆₀)/3)/e₄₀ | 2,08 | 2,35 | 2,10 | 1,67 |

Le tableau 3 résume pour ces exemples 1 à 4 les principales caractéristiques optiques mesurées pour le substrat porteur de l'empilement intégré dans un double vitrage de structure : verre de 6 mm / espace intercalaire de 15 mm rempli d'argon / verre de 6 mm, l'empilement étant positionné en face 2 (la face 1 du vitrage étant la face la plus à l'extérieur du vitrage, comme habituellement).

**Tableau 3**

| | | Ex. 1 | Ex. 2 | Ex. 3 | Ex. 4 |
|---|---|---|---|---|---|
| T_{L} | % | 60,0 | 59,8 | 59,9 | 61,7 |
| a*_{T} | | -8,4 | -8,0 | -7,2 | -11,4 |
| b*_{T} | | 3,3 | 4,0 | 3,1 | 4,2 |
| R_{Lext} | % | 12,5 | 12,6 | 12,1 | 9,1 |
| a*_{Rext} | | -1,9 | -3,7 | -3,0 | 9,4 |
| b*_{Rext} | | -4,8 | -9,2 | -3,1 | -12,4 |
| a*_{Rext-45°} | | -1,0 | -1,0 | -1,3 | 12,1 |
| b*_{Rext-45°} | | 3,2 | -2,1 | -1,9 | -1,5 |
| a*_{Rext-60°} | | -2,5 | -1,5 | -1,1 | 9,2 |
| b*_{Rext-60°} | | 3,5 | 0,0 | -1,8 | 1,2 |
| R_{Lint} | % | 14,0 | 14,1 | 16,1 | 11,0 |
| a*_{Rint} | | 0,4 | -0,7 | -1,5 | 9,1 |
| b*_{Rint} | | -5,7 | -5,3 | -1,1 | -10,3 |
| FS | % | 26,4 | 26,4 | 28,3 | 26,6 |

Pour ce double vitrage,
- T_{L} indique : la transmission lumineuse dans le visible en %, mesurée selon l'illuminant A à 10° Observateur ;
- a*_{T} et b*_{T} indiquent les couleurs en transmission a* et b* dans le système LAB mesurées selon l'illuminant D65 à 10° Observateur et mesurées ainsi sensiblement perpendiculairement au vitrage ;
- R_{bext} indique : la réflexion lumineuse dans le visible en %, mesurée selon l'illuminant A à 10° Observateur du côté de la face la plus à l'extérieur, la face 1 ;
- a*_{Rext} et b*_{Rext} indiquent les couleurs en réflexion a* et b* dans le système LAB mesurées selon l'illuminant D65 à 10° Observateur du côté de la face la plus à l'extérieur et mesurées ainsi sensiblement perpendiculairement au vitrage ;
- a*_{Rext-45°} et b*_{Rext-45°} indiquent les couleurs en réflexion a* et b* dans le système LAB mesurées selon l'illuminant D65 à 10° Observateur du côté de la face la plus à l'extérieur et mesurées sensiblement avec un angle de 45 ° par rapport à la perpendiculaire au vitrage.
- a*_{Rext-60°} et b*_{Rext-60°} indiquent les couleurs en réflexion a* et b* dans le système LAB mesurées selon l'illuminant D65 à 10° Observateur du côté de la face la plus à l'extérieur et mesurées sensiblement avec un angle de 60 ° par rapport à la perpendiculaire au vitrage ;
- R_{Lint} indique : la réflexion lumineuse dans le visible en %, mesurée selon l'illuminant A à 10° Observateur du côté de la face la plus à l'intérieur, la face 4 ;
- a*_{Rint} et b*_{Rint} indiquent les couleurs en réflexion a* et b* dans le système LAB mesurées selon l'illuminant D65 à 10° Observateur du côté de la face la plus à l'intérieur et mesurées ainsi sensiblement perpendiculairement au vitrage ;
- FS indique le facteur solaire, c'est-à-dire le pourcentage de l'énergie totale entrant dans le local à travers le vitrage sur l'énergie solaire incidente totale, calculé selon la norme EN 410.

Pour les exemples 1 et 2 selon l'invention, les trois couches fonctionnelles les plus éloignées du substrat présentent ainsi une épaisseur quasiment identiques : d'une part le rapport de l'épaisseur e₁₆₀ de la quatrième couche fonctionnelle sur l'épaisseur e₁₂₀ de la troisième couche fonctionnelle et d'autre part le rapport de l'épaisseur e₁₂₀ de la troisième couche fonctionnelle sur l'épaisseur e₈₀ de la deuxième couche fonctionnelle sont quasiment identiques; ces rapports sont compris entre 0,9 et 1,2 et même plus précisément entre 1,0 et 1,15.

Pour ces exemples 1 et 2 selon l'invention, la couche fonctionnelle la plus proche du substrat présente une épaisseur e₄₀ d'environ la moitié, voire inférieur à la moitié, de l'épaisseur e₈₀ de la deuxième couche fonctionnelle (cf. avant-dernière ligne du tableau 2) ; les rapports de l'épaisseur e₈₀ de la deuxième couche fonctionnelle sur l'épaisseur e₄₀ de la première couche fonctionnelle sont compris entre 1,9 et 2,2.

Pour ces exemples 1 et 2 selon l'invention, la couche fonctionnelle la plus proche du substrat présente une épaisseur e₄₀ d'environ la moitié, voire inférieur à la moitié, de l'épaisseur moyenne de toutes les autres couches fonctionnelles (cf. dernière ligne du tableau 2) ; ces rapports sont compris entre 1,9 et 2,5 et même plus précisément entre 2,0 et 2,4.

Pour l'exemple 3, qui n'est pas selon l'invention, les épaisseurs des couches fonctionnelles augmentent progressivement en s'éloignant du substrat, avec un rapport de l'ordre de 1,3 à 1,5 de l'épaisseur d'une couche fonctionnelle sur l'épaisseur de la couche fonctionnelle précédente en direction du substrat.

Pour l'exemple 3, qui n'est pas selon l'invention, même si la couche fonctionnelle la plus proche du substrat présente une épaisseur e₄₀ d'environ la moitié, de l'épaisseur moyenne de toutes les autres couches fonctionnelles (cf. dernière ligne du tableau 2), la couche fonctionnelle la plus proche du substrat ne présente pas une épaisseur e₄₀ d'environ la moitié de l'épaisseur e₈₀ de la deuxième couche fonctionnelle (cf. avant-dernière ligne du tableau 2).

Pour l'exemple 4, qui n'est pas selon l'invention, les trois couches fonctionnelles les plus éloignées du substrat présentent une épaisseur quasiment identiques : d'une part le rapport de l'épaisseur e₁₆₀ de la quatrième couche fonctionnelle sur l'épaisseur e₁₂₀ de la troisième couche fonctionnelle et d'autre part le rapport de l'épaisseur e₁₂₀ de la troisième couche fonctionnelle sur l'épaisseur e₈₀ de la deuxième couche fonctionnelle sont quasiment identiques ; ces rapports sont compris entre 0,9 et 1,2.

Pour l'exemple 4, qui n'est pas selon l'invention, la couche fonctionnelle la plus proche du substrat présente une épaisseur e₄₀ certes inférieure à l'épaisseur de la deuxième couche fonctionnelle (cf. avant-dernière ligne du tableau 2) mais le rapport de l'épaisseur e₈₀ de la deuxième couche fonctionnelle sur l'épaisseur e₄₀ de la première couche fonctionnelle est inférieur à 1,9.

Pour l'exemple 4, qui n'est pas selon l'invention, la couche fonctionnelle la plus proche du substrat présente une épaisseur qui est très supérieure à la moitié de l'épaisseur moyenne de toutes les autres couches fonctionnelles (cf. dernière ligne du tableau 2).

L'étude du tableau 3 montre qu'il est possible de réaliser un empilement à quatre couches fonctionnelles métalliques qui présente une réflexion lumineuse faible et plate dans tout le visible, avec des pentes très fortes dans l'UV et l'infrarouge et dont le spectre en transmission se rapproche ainsi nettement du spectre idéal passe-bande en créneau, permettant ainsi d'obtenir une sélectivité (rapport T_{L}/FS) très intéressante, de l'ordre de 60/26 ; c'est ce qui a été obtenu avec les exemples 1 et 2.

En outre, la couleur en réflexion, tant du côté extérieur que du côté intérieur est contenue dans les bleu-vert et varie peu avec l'angle, comme visible en figures 2 et 3 respectivement pour l'exemple 1 et 2.

Sur la figure 2, chacun peut retrouver pour l'exemple 1, les valeurs du tableau 3 pour la couleur en réflexion extérieure (« out », en trait continu) et notamment à 0°, c'est-à-dire à la normale, de a*_{Rext} = - 1,9 et b*_{Rext} = - 4,8 ; c'est le début de la courbe en trait continu.

Sur la figure 2, chacun peut retrouver pour l'exemple 1, les valeurs du tableau 3 pour la couleur en réflexion intérieure (« in », en trait discontinu) et notamment à 0°, c'est-à-dire à la normale, de a*_{Rext} = 0,4 et b*_{Rext} = - 5,7 ; c'est le début de la courbe en trait discontinu.

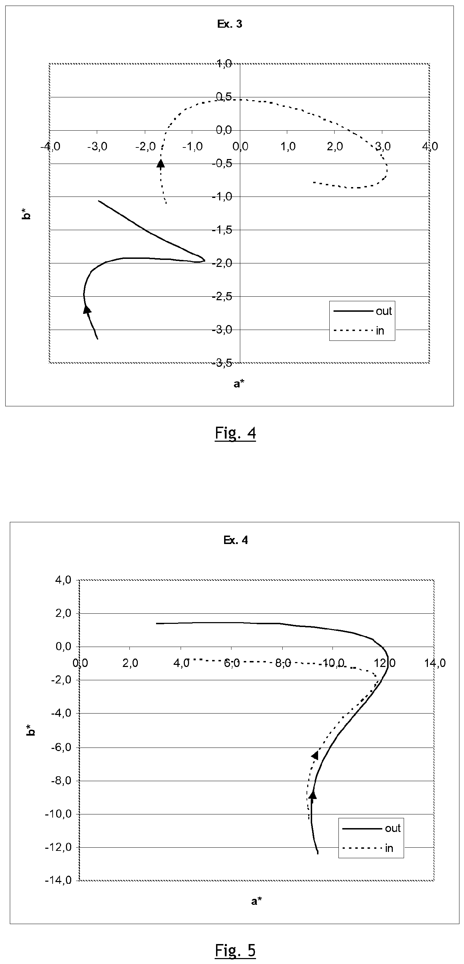

L'exemple 3 présente une sélectivité moins bonne que celle des exemples 1 et 2, d'environ 60/28. En outre, la couleur en réflexion, tant du côté extérieur que du côté intérieur varie beaucoup avec l'angle, comme visible en figure 4.

L'exemple 4 présente une sélectivité légèrement meilleure que celle des exemples 1 et 2, d'environ 61/26, mais présente une couleur en réflexion rougeâtre et qui varie beaucoup avec l'angle, comme visible en figure 5.

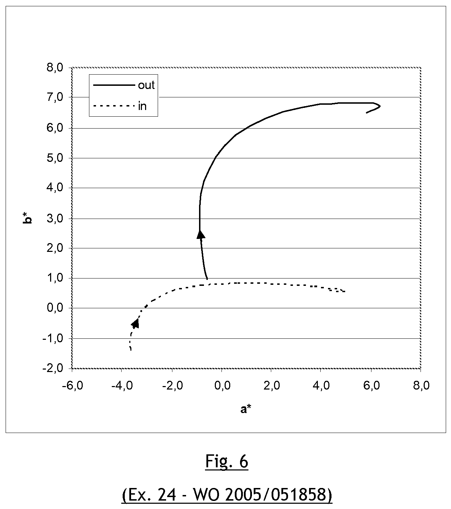

L'exemple 24 de la demande N° WO 2005/051858 a lui aussi fait l'objet d'une analyse par simulation, avec le même outil informatique que les exemples 1 à 4 précédents. Le résultat est illustré en figure 6.

Tant la couleur en réflexion extérieur que la couleur en réflexion intérieur varient beaucoup avec l'angle.

Pour l'exemple 5 ci-après, basé sur l'exemple 2 ci-avant, l'empilement de couches minces est déposé sur un substrat en verre sodo-calcique clair d'une épaisseur de 6 mm, distribué par la société SAINT-GOBAIN.

Pour cet exemple, les conditions de dépôt des couches, qui ont été déposées par pulvérisation (pulvérisation dite « cathodique magnétron »), sont les suivantes :

**Tableau 4**

| Couche | Cible employée | Pression de dépôt | Gaz | Indice à 550 nm |
|---|---|---|---|---|
| SiAlN | Si:Al à 92:8 % wt | 3,2.10⁻³ mbar | Ar /(Ar + N₂) à 55 % | 2,03 |
| ZnO | Zn:Al à 98:2 % wt | 18.10⁻³ mbar | Ar /(Ar + O₂) à 63 % | 1,95 |
| Ti | Ti | 2,5.10⁻³ mbar | Ar à 100 % | |
| Ag | Ag | 3.10⁻³ mbar | Ar à 100 % | |

Le tableau 5 suivant résume les matériaux et les épaisseurs en nanomètres de chaque couche et la composition des couches qui constituent l'empilement de l'exemple 5 en fonction de leurs positions vis-à-vis du substrat porteur de l'empilement (dernière ligne en bas du tableau) ; les numéros de la 1^{ère} et de la 2^{e} colonne, ainsi que les indices en dernière colonne correspondent aux références de la figure 1.

**Tableau 5**

| | | | Ex. 5 | Epaisseurs optiques (nm) |
|---|---|---|---|---|
| 180 | 184 | SiAlN | 36,3 | e₁₈₀ = 81,49 |
| | 182 | ZnO | 4 | |
| 175 | | Ti | 0,5 | |
| 160 | | Ag4 | 17,1 | |
| 140 | 148 | ZnO | 4 | e₁₄₀ = 168,86 |
| | 144 | SiAlN | 75,5 | |
| | 142 | ZnO | 4 | |
| 135 | | Ti | 0,5 | |
| 120 | | Ag3 | 15,8 | |
| 100 | 108 | ZnO | 4 | e₁₀₀ = 158,71 |
| | 104 | SiAlN | 70,5 | |
| | 102 | ZnO | 4 | |
| 95 | | Ti | 0,5 | |
| 80 | | Ag2 | 14,4 | |
| 60 | 68 | ZnO | 4 | e₆₀ = 156,89 |
| | 64 | SiAlN | 69,6 | |
| | 62 | ZnO | 4 | |
| 55 | | Ti | 0,5 | |
| 40 | | Ag1 | 6,6 | |
| 20 | 28 | Zn0 | 4 | e₂₀ = 41,70 |
| | 24 | SiAlN | 16,7 | |
| 10 | | Verre | | |

Chaque revêtement antireflet 20, 60, 100, 140 sous-jacent à une couche fonctionnelle 40, 80, 120, 160 comporte une dernière couche de mouillage 28, 68, 108, 148 à base d'oxyde de zinc cristallisé, dopé à l'aluminium et qui est au contact de la couche fonctionnelle 40, 80, 120, 160 déposée juste au-dessus.

Chaque revêtement antireflet 20, 60, 100, 140, 180 comporte une couche 24, 64, 104, 144, 184 à indice moyen, à base de nitrure de silicium, dopé à l'aluminium appelée ici SiAlN par soucis de simplification bien que la nature réelle de la couche soit en fait du Si₃N₄:Al comme expliqué ci-avant.

Ces couches à base de nitrure de silicium sont importantes pour obtenir l'effet barrière à l'oxygène lors du traitement thermique.

L'exemple 5 présente ainsi l'avantage supplémentaire d'être trempable et bombable.

Il a été vérifié que cet exemple 5 présente effectivement les caractéristiques annoncées pour l'exemple 2 dans le tableau 3 ci-avant, aux erreurs et incertitudes de mesure près et celles annoncées en figure 3.

Du fait de l'épaisseur totale importante des couches d'argent (et donc de la faible résistance par carré obtenue) ainsi que des bonnes propriétés optiques (en particulier la transmission lumineuse dans le visible), il est possible, par ailleurs d'utiliser le substrat revêtu de l'empilement selon l'invention pour réaliser un substrat électrode transparent.

Ce substrat électrode transparent peut convenir pour un dispositif électroluminescent organique, en particulier en remplaçant une partie de la couche 184 en nitrure de silicium de l'exemple 5 par une couche conductrice (avec en particulier une résistivité inférieure à 10⁵ Ω.cm) et notamment une couche à base d'oxyde. Cette couche peut être par exemple en oxyde d'étain ou à base d'oxyde de zinc éventuellement dopé Al ou Ga, ou à base d'oxyde mixte et notamment d'oxyde d'Indium et d'étain ITO, d'oxyde d'Indium et de zinc IZO, d'oxyde d'étain et de zinc SnZnO éventuellement dopé (par exemple avec Sb, F). Ce dispositif électroluminescent organique peut être utilisé pour réaliser un dispositif d'éclairage ou un dispositif de visualisation (écran).

D'une manière générale, le substrat électrode transparent peut convenir comme substrat chauffant pour un vitrage chauffant et en particulier un pare-brise feuilleté chauffant. Il peut aussi convenir comme substrat électrode transparent pour tout vitrage électrochrome, tout écran de visualisation, ou encore pour une cellule photovoltaïque et notamment pour une face avant ou une face arrière de cellule photovoltaïque transparente.

La présente invention est décrite dans ce qui précède à titre d'exemple. Il est entendu que l'homme du métier est à même de réaliser différentes variantes de l'invention sans pour autant sortir du cadre du brevet tel que défini par les revendications.

## Revendications

1. Substrat (10) verrier transparent, muni d'un empilement de couches minces comportant une alternance de quatre couches métalliques fonctionnelles (40, 80, 120, 160), notamment de couches fonctionnelles à base d'argent ou d'alliage métallique contenant de l'argent, et de cinq revêtements antireflet (20, 60, 100, 140, 180), chaque revêtement antireflet comportant au moins une couche antireflet, de manière à ce que chaque couche métallique fonctionnelle (40, 80, 120, 160) soit disposée entre deux revêtements antireflet (20, 60, 100, 140, 180), l'épaisseur des deuxième, troisième et quatrième couches métalliques fonctionnelles (80, 120, 160) en partant du substrat étant sensiblement identique avec un rapport de l'épaisseur d'une couche sur l'épaisseur de la précédente qui est compris entre 0,9 et 1,1 en incluant ces valeurs et **caractérisé en ce que** l'épaisseur de la première couche métallique fonctionnelle (40) est environ la moitié de l'épaisseur de la deuxième couche métallique fonctionnelle (80) avec un rapport de l'épaisseur de la deuxième couche métallique sur l'épaisseur de la première couche métallique fonctionnelle (40) qui est compris entre 1,9 et 2,2 en incluant ces valeurs.

2. Substrat (10) selon la revendication 1, ***caractérisé en ce que*** chaque revêtement antireflet (60, 100, 140) situé entre deux couches métalliques fonctionnelles présente une épaisseur optique comprise entre 165 nm et 181 nm en incluant ces valeurs.

3. Substrat (10) selon la revendication 1 ou la revendication 2, ***caractérisé en ce que*** l'épaisseur de la première couche métallique fonctionnelle (40) est environ la moitié de l'épaisseur de toutes les autres couches métalliques fonctionnelles (80, 120, 160) avec un rapport de la moyenne de l'épaisseur des deuxième, troisième et quatrième couches métalliques fonctionnelles sur l'épaisseur de la première couche métallique fonctionnelle (40) qui est compris entre 1,9 et 2,5 en incluant ces valeurs.

4. Substrat (10) selon l'une quelconque des revendications 1 à 3, ***caractérisé en ce que*** l'épaisseur e₄₀ en nm de la première couche métallique fonctionnelle (40) en partant du substrat est telle que : 5,5 ≤ e₄₀ ≤ 11 en nm, et de préférence 6 ≤ e₄₀ ≤ 10.

5. Substrat (10) selon l'une quelconque des revendications 1 à 4, ***caractérisé en ce que*** l'épaisseur e₈₀ en nm de la deuxième couche métallique fonctionnelle (80) en partant du substrat est telle que : 11 ≤ e₈₀ ≤ 22 en nm, et de préférence 12 ≤ e₈₀ ≤ 20.

6. Substrat (10) selon l'une quelconque des revendications 1 à 5, ***caractérisé en ce que*** l'épaisseur e₁₂₀ en nm de la troisième couche métallique fonctionnelle (120) en partant du substrat est telle que : 11 ≤ e₁₂₀ ≤ 22 en nm, et de préférence 12 ≤ e₁₂₀ ≤ 20.

7. Substrat (10) selon l'une quelconque des revendications 1 à 6, ***caractérisé en ce que*** l'épaisseur e₁₆₀ en nm de la quatrième couche métallique fonctionnelle (160) en partant du substrat est telle que : 11 ≤ e₁₆₀ ≤ 22 en nm, et de préférence 12 ≤ e₁₆₀ ≤ 20.

8. Substrat (10) selon l'une quelconque des revendications 1 à 7, ***caractérisé en ce que*** l'épaisseur totale des quatre couches métalliques fonctionnelles (40, 80, 120, 160) est comprise entre 30 et 70 nm en incluant ces valeurs, voire cette épaisseur totale est comprise entre 35 et 65 nm.

9. Substrat (10) selon l'une quelconque des revendications 1 à 8, ***caractérisé en ce que*** chacun des revêtements antireflet (20, 60, 100, 140, 180) comporte au moins une couche antireflet (24, 64, 104, 144, 184) à base de nitrure de silicium, éventuellement dopé à l'aide d'au moins un autre élément, comme l'aluminium.

10. Substrat (10) selon l'une quelconque des revendications 1 à 9, ***caractérisé en ce que*** la dernière couche de chaque revêtement antireflet sous-jacent à une couche fonctionnelle (40, 80, 120, 160) est une couche antireflet de mouillage (28, 68, 108, 148) à base d'oxyde cristallisé, notamment à base d'oxyde de zinc, éventuellement dopé à l'aide d'au moins un autre élément, comme l'aluminium.

11. Vitrage incorporant au moins un substrat (10) selon l'une quelconque des revendications 1 à 10, éventuellement associé à au moins un autre substrat et notamment vitrage multiple du type double-vitrage ou triple vitrage ou vitrage feuilleté et en particulier vitrage feuilleté comportant des moyens pour la connexion électrique de l'empilement de couches minces afin de permettre de réaliser un vitrage feuilleté chauffant, ledit substrat porteur de l'empilement pouvant être bombé et/ou trempé.

12. Utilisation du substrat selon l'une quelconque des revendications 1 à 10, pour réaliser un revêtement transparent chauffant d'un vitrage chauffant ou pour réaliser une électrode transparente d'un vitrage électrochrome ou d'un dispositif d'éclairage ou d'un dispositif de visualisation ou d'un panneau photovoltaïque.

## Patentansprüche

1. Transparentes Glassubstrat (10), das mit einem Stapel von dünnen Schichten versehen ist, umfassend eine Wechselfolge von vier metallischen Funktionsschichten (40, 80, 120, 160), insbesondere von Funktionsschichten auf Basis von Silber oder einer Metalllegierung, die Silber enthält, und fünf Antireflex-Überzügen (20, 60, 100, 140, 180), wobei jeder Antireflex-Überzug mindestens eine Antireflex-Schicht umfasst, so dass jede metallische Funktionsschicht (40, 80, 120, 160) zwischen zwei Antireflex-Überzügen (20, 60, 100, 140, 180) angeordnet ist, wobei die Dicke der zweiten, dritten und vierten metallischen Funktionsschicht (80, 120, 160) ausgehend vom Substrat im Wesentlichen identisch mit einem Verhältnis der Dicke einer Schicht zur Dicke der vorhergehenden ist, das zwischen 0,9 und 1,1 inklusive dieser Werte beträgt, und **dadurch gekennzeichnet, dass** die Dicke der ersten metallischen Funktionsschicht (40) ungefähr die Hälfte der Dicke der zweiten metallischen Funktionsschicht (80) mit einem Verhältnis der Dicke der zweiten metallischen Schicht zur Dicke der ersten metallischen Funktionsschicht (40), das zwischen 1,9 und 2,2 inklusive dieser Werte beträgt, ist.

2. Substrat (10) nach Anspruch 1, **dadurch gekennzeichnet, dass** jeder Antireflex-Überzug (60, 100, 140), der sich zwischen zwei metallischen Funktionsschichten befindet, eine optische Dicke zwischen 165 nm und 181 nm inklusive dieser Werte aufweist.

3. Substrat (10) nach Anspruch 1 oder Anspruch 2, **dadurch gekennzeichnet, dass** die Dicke der ersten metallischen Funktionsschicht (40) ungefähr die Hälfte der Dicke aller anderen metallischen Funktionsschichten (80, 120, 160) ist, mit einem Verhältnis des Durchschnitts der Dicke der zweiten, dritten und vierten metallischen Funktionsschicht zur Dicke der ersten metallischen Funktionsschicht (40), das zwischen 1,9 und 2,5 inklusive dieser Werte beträgt.

4. Substrat (10) nach einem der Ansprüche 1 bis 3, **dadurch gekennzeichnet, dass** die Dicke e₄₀ in nm der ersten metallischen Funktionsschicht (40) ausgehend vom Substrat derart ist, dass: 5,5 ≤ e₄₀ ≤ 11 in nm und vorzugsweise 6 ≤ e₄₀ ≤ 10.

5. Substrat (10) nach einem der Ansprüche 1 bis 4, **dadurch gekennzeichnet, dass** die Dicke e₈₀ in nm der zweiten metallischen Funktionsschicht (80) ausgehend vom Substrat derart ist, dass: 11 ≤ e₈₀ ≤ 22 in nm und vorzugsweise 12 ≤ e₈₀ ≤ 20.

6. Substrat (10) nach einem der Ansprüche 1 bis 5, **dadurch gekennzeichnet, dass** die Dicke e₁₂₀ in nm der dritten metallischen Funktionsschicht (120) ausgehend vom Substrat derart ist, dass: 11 ≤ e₁₂₀ ≤ 22 in nm und vorzugsweise 12 ≤ e₁₂₀ ≤ 20.

7. Substrat (10) nach einem der Ansprüche 1 bis 6, **dadurch gekennzeichnet, dass** die Dicke e₁₆₀ in nm der vierten metallischen Funktionsschicht (160) ausgehend vom Substrat derart ist, dass: 11 ≤ e₁₆₀ ≤ 22 in nm und vorzugsweise 12 ≤ e₁₆₀ ≤ 20.

8. Substrat (10) nach einem der Ansprüche 1 bis 7, **dadurch gekennzeichnet, dass** die Gesamtdicke der vier metallischen Funktionsschichten (40, 80, 120, 160) zwischen 30 und 70 nm inklusive dieser Werte beträgt, bzw. diese Gesamtdicke zwischen 35 und 65 nm beträgt.

9. Substrat (10) nach einem der Ansprüche 1 bis 8, **dadurch gekennzeichnet, dass** jeder der Antireflex-Überzüge (20, 60, 100, 140, 180) mindestens eine Antireflex-Schicht (24, 64, 104, 144, 184) auf Basis von Siliziumnitrid, das eventuell mit Hilfe mindestens eines weiteren Elements, wie Aluminium, dotiert ist, umfasst.

10. Substrat (10) nach einem der Ansprüche 1 bis 9, **dadurch gekennzeichnet, dass** die letzte Schicht jedes Antireflex-Überzugs, der unter einer Funktionsschicht (40, 80, 120, 160) angeordnet ist, eine benetzende Antireflex-Schicht (28, 68, 108, 148) auf Basis von kristallisiertem Oxid, insbesondere auf Basis von Zinkoxid, eventuell dotiert mit Hilfe mindestens eines weiteren Elements, wie Aluminium, ist.

11. Verglasung, umfassend mindestens ein Substrat (10) nach einem der Ansprüche 1 bis 10, eventuell in Verbindung mit mindestens einem weiteren Substrat, und eventuell Mehrfachverglasung vom Typ Zweifachverglasung oder Dreifachverglasung oder Verbundverglasung und insbesondere Verbundverglasung, umfassend Mittel für den elektrischen Anschluss des Stapels von dünnen Schichten, um die Herstellung einer Heizverbundverglasung zu ermöglichen, wobei das Substrat, das den Stapel trägt, gebogen und/oder gehärtet sein kann.

12. Verwendung des Substrats nach einem der Ansprüche 1 bis 10 für die Herstellung eines transparenten Heizüberzugs einer Heizverglasung oder für die Herstellung einer transparenten Elektrode einer elektrochromen Verglasung oder einer Beleuchtungsvorrichtung oder einer Anzeigevorrichtung oder einer Photovoltaikplatte.

## Claims

1. A transparent glass substrate (10), provided with a thin-film multilayer comprising an alternation of four functional metallic layers (40, 80, 120, 160), especially of functional layers based on silver or a on metal alloy containing silver, and of five antireflection coatings (20, 60, 100, 140, 180), each antireflection coating comprising at least one antireflection layer, so that each functional metallic layer (40, 80, 120, 160) is positioned between two antireflection coatings (20, 60, 100, 140, 180), the thickness of the second, third and fourth functional metallic layers (80, 120, 160) starting from the substrate being substantially identical, with a ratio of the thickness of one layer to the thickness of the preceding layer that is between 0.9 and 1.1 inclusive of these values, and ***characterized in that*** the thickness of the first functional metallic layer (40) is around half the thickness of the second functional metallic layer (80), with a ratio of the thickness of the second metallic layer to the thickness of the first functional metallic layer (40) that is between 1.9 and 2.2 inclusive of these values.

2. The substrate (10) as claimed in claim 1, ***characterized in that*** each antireflection coating (60, 100, 140) located between two functional metallic layers has an optical thickness between 165 nm and 181 nm inclusive of these values.

3. The substrate (10) as claimed in claim 1 or claim 2, ***characterized in that*** the thickness of the first functional metallic layer (40) is around half the thickness of all the other functional metallic layers (80, 120, 160), with a ratio of the average of the thickness of the second, third and fourth functional metallic layers to the thickness of the first functional metallic layer (40) that is between 1.9 and 2.5 inclusive of these values.

4. The substrate (10) as claimed in any one of claims 1 to 3, ***characterized in that*** the thickness e₄₀ in nm of the first functional metallic layer (40) starting from the substrate is such that: 5.5 ≤ e₄₀ ≤ 11 in nm, and preferably 6 ≤ e₄₀ ≤ 10.

5. The substrate (10) as claimed in any one of claims 1 to 4, ***characterized in that*** the thickness e₈₀ in nm of the second functional metallic layer (80) starting from the substrate is such that: 11 ≤ e₈₀ ≤ 22 in nm, and preferably 12 ≤ e₈₀ ≤ 20.

6. The substrate (10) as claimed in any one of claims 1 to 5, ***characterized in that*** the thickness e₁₂₀ in nm of the third functional metallic layer (120) starting from the substrate is such that: 11 ≤ e₁₂₀ ≤ 22 in nm, and preferably 12 ≤ e₁₂₀ ≤ 20.

7. The substrate (10) as claimed in any one of claims 1 to 6, ***characterized in that*** the thickness e₁₆₀ in nm of the fourth functional metallic layer (160) starting from the substrate is such that: 11 ≤ e₁₆₀ ≤ 22 in nm, and preferably 12 ≤ e₁₆₀ ≤ 20.

8. The substrate (10) as claimed in any one of claims 1 to 7, ***characterized in that*** the total thickness of the four functional metallic layers (40, 80, 120, 160) is between 30 and 70 nm inclusive of these values, or even this total thickness is between 35 and 65 nm.

9. The substrate (10) as claimed in any one of claims 1 to 8, ***characterized in that*** each of the antireflection coatings (20, 60, 100, 140, 180) comprises at least one antireflection layer (24, 64, 104, 144, 184) based on silicon nitride, optionally doped with the aid of at least one other element, such as aluminum.

10. The substrate (10) as claimed in any one of claims 1 to 9, ***characterized in that*** the last layer of each antireflection coating subjacent to a functional layer (40, 80, 120, 160) is an antireflection wetting layer (28, 68, 108, 148) based on crystalline oxide, especially based on zinc oxide, optionally doped with the aid of at least one other element, such as aluminum.

11. Glazing incorporating at least one substrate (10) as claimed in any one of claims 1 to 10, optionally combined with at least one other substrate and especially multiple glazing of the double glazing or triple glazing or laminated glazing type and in particular laminated glazing comprising means for the electrical connection of the thin-film multilayer in order to make it possible to produce heated laminated glazing, it being possible for said substrate bearing the multilayer to be bent and/or tempered.

12. The use of the substrate as claimed in any one of claims 1 to 10, for producing a heated transparent coating of heated glazing or for producing a transparent electrode of electrochromic glazing or of a lighting device or of a display device or of a photovoltaic panel.
